# FASCICULE DE BREVET EUROPEEN

(11) **EP 3 271 931 B1**
(45) Date de publication et mention de la délivrance du brevet: **21.11.2018**
(21) Numéro de dépôt: 16707703.1
(22) Date de dépôt: 29.02.2016
(51) Int. Cl.: H01H 9/02, H05K 5/02

(54) **DISPOSITIF DE TÉLÉCOMMANDE COMPORTANT UNE TÉLÉCOMMANDE NOMADE ET UN SUPPORT MURAL**
FERNBEDIENUNGSVORRICHTUNG MIT EINER TRAGBAREN FERNBEDIENUNG UND EINER WANDHALTERUNG
REMOTE-CONTROL DEVICE COMPRISING A PORTABLE REMOTE CONTROL AND A WALL MOUNTING

(30) Priorité: 20.03.2015 FR 1552341
(43) Date de publication de la demande: 24.01.2018
(73) Titulaire: SOMFY ACTIVITES SA, 74300 Cluses (FR)
(72) Inventeur: ESCURIER, Pierre, 74130 Bonneville (FR); LE GOUEFF, Alizé, 74960 Cran-Gevrier (FR); STRUBI, Frédéric, 69005 Lyon (FR); BAJARD, Philippe, 69005 Lyon (FR); DESAGRE, Thomas, 74300 Cluses (FR)
(74) Mandataire: Bugnion Genève
(86) Numéro de dépôt international: PCT/EP2016/054215
(87) Numéro de publication internationale: WO 2016/150656

(56) Documents cités:
- FR-A1- 2 794 928
- JP-A- H07 327 284
- US-A1- 2007 272 044

## Description

### DOMAINE TECHNIQUE DE L'INVENTION

La présente invention concerne un dispositif de télécommande comportant une télécommande nomade et son support mural, en particulier pour la télécommande d'équipements domotiques d'un bâtiment.

### ÉTAT DE LA TECHNIQUE ANTÉRIEURE

La notice d'installation de la télécommande Telis® de la société Somfy® datant de mai 2006 et disponible à l'adresse https://www.somfy.fr/file.cfm/notice telis1rts.pdf?contentID=38970 illustre un exemple d'une télécommande nomade, c'est-à-dire apte à être prise en main et déplacée tout en restant fonctionnelle, donc incluant au moins une alimentation autonome en énergie et des moyens de communication sans fil à distance avec des équipements domotiques, que l'on peut accrocher à un support mural, que l'on peut positionner à tout endroit souhaité, par exemple à proximité de l'équipement domotique appairé à la télécommande, ou à l'entrée d'une pièce, pour ranger la télécommande. À cet effet, le boîtier de la télécommande présente un oeillet dans lequel vient se loger la tête d'une tige fixée dans le mur et constituant le support, permettant ainsi l'accrochage de la télécommande au support. Mais on constate à l'usage qu'il n'est pas toujours aisé d'accrocher la télécommande, notamment parce qu'à l'approche du mur, l'utilisateur présente naturellement la télécommande avec une inclinaison qui ne facilite pas l'insertion de la tête du support dans l'oeillet. De plus, la taille de la tête du support est volontairement réduite pour ne pas faire une saillie trop importante à partir de la surface du mur, de sorte que l'accrochage n'est pas très sécurisé. Enfin, la tête a une forme cylindrique et forme un pivot, de sorte que la télécommande accrochée est supposée trouver par gravité une position verticale. Ainsi, si la télécommande est bousculée, elle a tendance à penduler voire à quitter son support. De plus, ces degrés de liberté contraignent, lorsque l'on souhaite utiliser la télécommande sur son support, à la maintenir en position d'une main tout en la manipulant de l'autre. Le document "FR 2 794 928 A1 " décrit un dispositif de télécommande selon le préambule de la revendication 1.

### EXPOSÉ DE L'INVENTION

L'invention vise à remédier à au moins certains des inconvénients de l'état de la technique et à proposer des moyens simples pour un accrochage amélioré d'une télécommande nomade à un support mural.

Pour ce faire est proposé, suivant un premier aspect de l'invention, un dispositif de télécommande comportant une télécommande nomade et un support mural, la télécommande nomade comportant un boîtier présentant une face arrière et une face avant, situées de part et d'autre et à distance d'un plan médian du boîtier, le boîtier comprenant une cavité ouverte au moins sur la face arrière, le support mural présentant une surface d'appui à un mur suivant un plan d'appui et une tête faisant saillie par rapport au plan d'appui, la tête pénétrant dans la cavité dans une position d'accrochage de la télécommande nomade de manière à traverser le plan médian du boîtier, caractérisé en ce que la cavité est conformée de manière à épouser la forme de la tête, en ce que la tête fait saillie dans une direction oblique ascendante par rapport au plan d'appui, et présente au moins une première surface oblique qui, en position d'accrochage, est en contact surfacique avec au moins une première paroi oblique de la cavité.

Grâce à l'orientation oblique de surfaces de la tête du support et de la cavité du boîtier, il est possible, pour un encombrement donné mesuré perpendiculairement au plan d'appui, d'augmenter l'aire des surfaces en contact de la tête du support et de la télécommande, donc d'augmenter la surface de contact ou de friction entre la tête et la ou les parois obliques de la cavité. Par la coopération de forme, la cavité épousant la forme de la tête, on limite également les jeux entre le support et la télécommande de sorte que celle-ci est parfaitement maintenue. De plus, l'orientation de la tête et de la cavité permet une indexation de la position de la télécommande par rapport au support, c'est-à-dire un positionnement relatif unique constituant la position d'accrochage, lorsque la tête est insérée dans la cavité.

L'angle des surfaces obliques est de préférence inférieur à 60° par rapport à la verticale, de préférence compris entre 30° et 60°.

De préférence, au moins une partie de la première paroi oblique située d'un côté du plan médian opposé à la face arrière étant située dans une moitié supérieure du boîtier, ce qui contribue à une bonne stabilité de la télécommande sur le support mural, par gravité.

Suivant un mode de réalisation préféré, la tête présente une deuxième surface oblique qui, en position d'accrochage, est en contact surfacique avec au moins une deuxième paroi oblique de la cavité. De préférence, la première et la deuxième surfaces obliques se rapprochent l'une de l'autre lorsque l'on s'éloigne de la face arrière du boîtier de la télécommande. On garantit ainsi un excellent accrochage.

De préférence, la première surface oblique de la tête du support mural et la première paroi oblique de la cavité sont au moins partiellement courbes. La courbure des surfaces obliques permet une insertion ou un retrait de la télécommande sans risque de blocage dans une position intermédiaire qui ne serait pas celle de la position d'accrochage. La forme de la tête et la forme correspondante de la cavité de l'oeillet définissent ainsi de manière univoque la position d'accrochage. L'utilisation de surfaces obliques courbes permet également d'insérer ou de retirer la télécommande du support, quelle que soit la direction donnée à la télécommande, c'est-à-dire qu'elle soit verticale ou légèrement oblique.

Suivant un mode de réalisation préféré, la cavité est ouverte sur la face avant du boîtier et forme un passage entre la face arrière et la face avant du boîtier. Le boîtier de la télécommande forme un oeillet délimitant la cavité. De préférence, la tête présente une facette sommitale qui, en position d'accrochage, affleure au niveau de la face avant de la télécommande nomade, en continuité de forme avec la face avant de la télécommande nomade. En position d'accrochage, l'ouverture en face avant est fermée par la facette sommitale de la tête du support mural de sorte que la face avant de la télécommande apparaît, vu de face, comme une télécommande sans oeillet. Cette disposition permet de minimiser l'aspect du support sur la télécommande.

De préférence, au moins une arête, en particulier une arête inférieure, de la facette sommitale est une arête arrondie. Cette arête arrondie permet de limiter le risque de blocage de la télécommande par rapport au support lorsque celle-ci est mise en place ou plus particulièrement lorsque la télécommande est retirée de son support. En effet, si la télécommande est soulevée par sa partie inférieure, la surface oblique de la cavité peut glisser sur l'arête arrondie de la facette sommitale du support, ce qui libère la télécommande du support. On évite ainsi les efforts d'arrachement sur le support. De préférence, au moins une arête, en particulier une arête inférieure, de la facette sommitale est une arête arrondie.

On peut prévoir que la tête du support mural ne présente pas de symétrie de révolution.

De préférence le support mural comporte un corps présentant une face arrière plane d'appui matérialisant le plan d'appui et constituant la surface d'appui, le corps du support mural présentant une face avant opposée à la face plane d'appui, la face arrière du boîtier de la télécommande nomade épousant la forme de la face avant du corps du support mural de manière être en contact surfacique avec la face avant du corps du support mural en position d'accrochage. Les formes conjuguées de la face avant du corps du support et de la face arrière de la télécommande contribuent également à un parfait positionnement de la télécommande sur le support mural. Un contact surfacique permet également d'éviter une quelconque accumulation de poussière entre le support mural et la télécommande si la télécommande doit rester accrochée pendant une longue période dans un environnement poussiéreux. Cette disposition permet également d'augmenter les surfaces en contact du support et de la télécommande pour assurer un meilleur maintien de la télécommande sur son support. De préférence, la face avant du corps du support mural est entièrement recouverte par la télécommande nomade en position d'accrochage. Ainsi, le support est masqué par la télécommande en position d'accrochage, seule est visible sa facette sommitale.

Suivant un mode de réalisation la face avant du corps du support mural est courbe, de préférence convexe. Mais une forme concave ou plane est également possible.

Suivant un mode de réalisation le boîtier de la télécommande comporte des rebords latéraux qui encadrent des faces latérales du corps du support mural en position d'accrochage. Les rebords contribuent à un bon positionnement latéral de la télécommande en position accrochée.

De préférence les rebords latéraux sont réalisés en un matériau différant de la face arrière du boîtier de la télécommande. Un matériau ayant un coefficient de friction plus élevé ou plus d'élasticité permet de mieux caler les rebords latéraux de part et d'autre du corps du support.

De préférence, la face arrière du boîtier de la télécommande comporte une portion d'extrémité inférieure qui, en position d'accrochage, est tangente au plan d'appui ou distante de moins d'un millimètre du plan d'appui. La partie de la face arrière de la télécommande qui est tangente ou quasiment tangente au plan d'appui contribue à un bon positionnement de la télécommande sur le support en position d'accrochage. Elle évite un décrochement de la télécommande si l'on appuie sur la partie inférieure de la face avant de la télécommande en position d'accrochage.

Dans un plan de coupe quelconque perpendiculaire à la direction oblique de la tête, on peut mesurer une largeur de la tête du support mural perpendiculairement au plan de symétrie du support mural, et une épaisseur de la tête du support mural dans le plan de symétrie du support mural. La largeur est de préférence plus grande que l'épaisseur, de préférence dans un rapport supérieure à 3/2. La largeur importante de la tête contribue à un bon accrochage. Suivant un mode de réalisation la tête a une largeur maximale, mesurée perpendiculairement à un plan de référence contenant la direction oblique d'insertion et perpendiculaire au plan d'appui, qui est supérieure ou égale à la moitié d'une largeur maximale de la télécommande nomade, mesurée en position d'accrochage perpendiculairement au plan de référence.

On peut ainsi contrôler le bon accrochage de la télécommande. On peut également prévoir un contraste de couleur entre la télécommande et cette facette sommitale. S'il y a un besoin de repérage lumineux du support mural, par exemple pour une utilisation dans un bâtiment tertiaire ou industriel, on peut envisager une diode électroluminescente à éclairage intermittent disposée au niveau de la facette sommitale, alimentée par une batterie logée dans le support mural, ou par un branchement électrique au réseau électrique du bâtiment, passant dans le mur.

En pratique, la face avant du boîtier de la télécommande nomade est équipée d'une interface de saisie. L'interface de saisie peut comporter une ou plusieurs touches, une molette, un écran tactile ou une combinaison de tels éléments. De préférence, on fait en sorte qu'en position d'accrochage, l'interface de saisie se trouve intégralement entre une extrémité inférieure et une extrémité supérieure du support mural, ou du moins que les parties de l'interface de saisie destinées à subir des pressions de commande de la part de l'utilisateur se trouve intégralement entre une extrémité inférieure et une extrémité supérieure du support mural. On évite ainsi tout risque de décrochement de la télécommande si elle est actionnée en position d'accrochage.

Il est à noter que le support mural peut également avoir une fonction de recharge électrique de la télécommande, par induction électromagnétique entre un circuit d'excitation situé dans la tête ou le corps du support, et un circuit récepteur relié à un accumulateur dans le boîtier de la télécommande.

En pratique, le boîtier de la télécommande nomade présente de préférence un plan de symétrie perpendiculaire au plan d'appui en position d'accrochage.

Suivant un autre aspect de l'invention, celle-ci a trait à une télécommande nomade destinée à constituer avec un support mural un dispositif de télécommande selon l'une quelconque des revendications précédentes, la télécommande nomade comportant un boîtier présentant une face arrière et une face avant, situées de part et d'autre et à distance d'un plan médian du boîtier, le boîtier ayant une extrémité supérieure et une extrémité inférieure, et comprenant une cavité ouverte au moins sur la face arrière et traversant le plan médian du boîtier. La cavité comporte au moins une première paroi oblique ascendante lorsque l'on s'éloigne de la face arrière. De préférence, au moins une partie de la première paroi oblique située d'un côté du plan médian opposé à la face arrière est située dans une moitié supérieure du boîtier. Avantageusement, la cavité présente une section, mesurée dans un plan de mesure quelconque parallèle au plan médian du boîtier, qui se réduit lorsque le plan de mesure s'éloigne de la face arrière. La télécommande présente ainsi une continuité de surface à l'arrière.

Suivant un autre aspect de l'invention, celle-ci a trait à une télécommande nomade destinée à constituer avec un support mural un dispositif de télécommande selon l'une quelconque des revendications précédentes, la télécommande nomade comportant un boîtier présentant une face arrière et une face avant, situées de part et d'autre et à distance d'un plan médian du boîtier, le boîtier ayant une extrémité supérieure et une extrémité inférieure, et comprenant une cavité ouverte au moins sur la face arrière et traversant le plan médian du boîtier. La cavité s'évase sur la face arrière du boîtier pour former un renfoncement de la face arrière, allongé en direction de l'extrémité inférieure du boîtier, ce qui permet d'accrocher la télécommande sur un support présentant une tête et un corps disposé sous cette tête. La cavité comporte de préférence au moins une première paroi oblique ascendante lorsque l'on s'éloigne de la face arrière. De préférence, au moins une partie de la première paroi oblique située d'un côté du plan médian opposé à la face arrière est située dans une moitié supérieure du boîtier.

### BRÈVE DESCRIPTION DES FIGURES

D'autres caractéristiques et avantages de l'invention ressortiront à la lecture de la description qui suit, en référence aux figures annexées, qui illustrent :
- la figure 1 une vue en perspective d'une télécommande nomade selon un mode de réalisation de l'invention, sous un angle permettant de visualiser une face avant d'un boîtier de la télécommande;
- la figure 2, une vue en perspective d'un support mural du dispositif de télécommande, associé à la télécommande nomade de la figure 1;
- la figure 3, une autre en perspective de la télécommande nomade de la figure 1, sous un angle permettant de visualiser une face arrière du boîtier de la télécommande
- la figure 4, une vue de côté d'un dispositif de télécommande selon l'invention, incorporant la télécommande de la figure 1 et le support mural de la figure 2,
- la figure 5, une vue en coupe dans un plan de coupe V-V qui constitue un plan de symétrie du boîtier de la télécommande et un plan de symétrie du support mural;
- la figure 6, une vue en coupe du dispositif de télécommande de la figure 4, dans un plan de coupe VI-VI perpendiculaire au plan de coupe V-V;
- la figure 7, une vue vue en coupe du dispositif de télécommande de la figure 4, dans un plan de coupe VII-VII parallèle au plan de coupe VI-VI.

Pour plus de clarté, les éléments identiques seront repérés par des signes de référence identiques sur l'ensemble des figures.

### DESCRIPTION DÉTAILLÉE DE MODES DE RÉALISATION

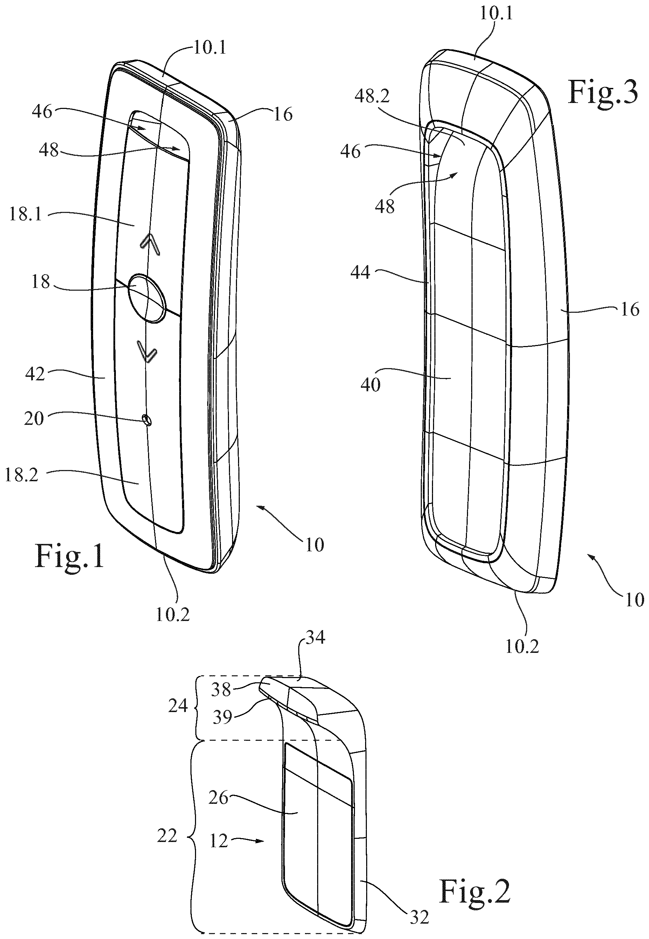

Les figures 1 et 3 illustrent sous deux angles de vue différents une télécommande nomade **10** destinée à être accrochée à un support mural **12** illustré sur la figure 2, dans une position d'accrochage illustrée sur les figures 3 à 5 et formant avec le support mural un dispositif de télécommande **14.**

De façon connue en soi, la télécommande nomade **10** est destinée à être tenue en main par un utilisateur et sert à commander un ou plusieurs équipements domotiques (non illustrés) dans une installation domotique depuis une position variable dans un bâtiment, par exemple à l'intérieur d'une pièce où se trouvent le ou les équipements domotiques appairés à la télécommande.

Volontairement, la représentation de la télécommande nomade **10** a été limitée à son boîtier **16,** mais l'homme du métier sait qu'une telle télécommande comporte un circuit électronique de commande relié à une interface de saisie dont on reconnaîtra ici trois touches **18, 18.1, 18.2,** le cas échéant à une interface visuelle, ici sous forme d'une diode électroluminescente **20,** et à une interface de télécommunication, de préférence sans fil, par exemple par voie radioélectrique, ainsi qu'à une source d'énergie qui peut inclure un accumulateur d'énergie et éventuellement des moyens pour recharger cet accumulateur, qui peuvent consister par exemple en une cellule photoélectrique ou en un enroulement destiné à être positionné dans un champ électromagnétique. De même, le support mural peut lui même inclure un circuit d'alimentation pour alimenter un enroulement inducteur.

Le support mural **12** est constitué ici en deux pièces assemblées par exemple par emboîtement et/ou clipsage, qui forment ensemble un corps **22** allongé relativement plat et une tête **24** saillante. Le corps présente une face avant **26** légèrement bombée, une face arrière **28** d'appui contre un mur **30** définissant un plan d'appui **P** et des faces latérales **32.** La fixation du support mural **12** au mur **30** peut être réalisée par tout moyen approprié, par exemple par des vis (non représentées) ou par collage, le cas échéant par l'intermédiaire d'un ruban à deux faces adhésives.

La tête **24** du support mural **12** fait saillie à une extrémité supérieure du corps **22** dans une direction axiale **D** oblique ascendante par rapport au plan d'appui **P.** L'angle A de la direction axiale oblique **D** est ici de l'ordre de 55°, mais peut varier en pratique entre 30° et 70°. La tête **24** du support mural **12** ne présente pas de symétrie de révolution et a une section, mesurée dans un plan parallèle au plan d'appui **P,** qui diminue lorsque l'on s'éloigne du plan d'appui **P.** La tête **24** du support mural **12** est en porte-à-faux par rapport au corps **22,** et présente ainsi une face arrière **34** tournée vers le plan d'appui **P.** La tête **24** présente également une face avant **36** qui est dans le prolongement de la face avant **26** du corps, de préférence sans rupture de pente avec cette dernière, et une face sommitale **38,** qui peut le cas échéant avoir une couleur ou un aspect de surface différent de la face avant. La transition entre la face avant **36** de la tête et la face sommitale **38** forme une arête **39** qui est de préférence arrondie.

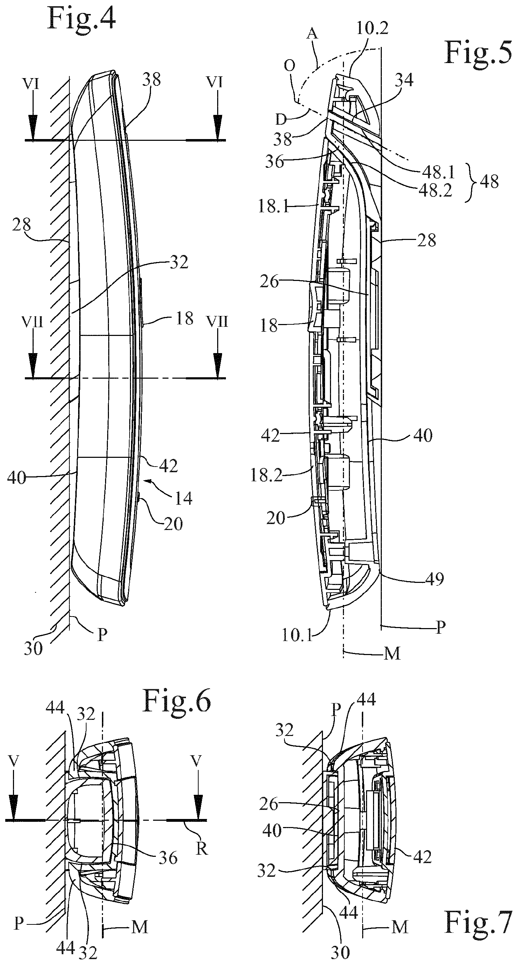

On peut définir un plan de référence **R** médian du support mural, perpendiculaire au plan d'appui **P** et dans lequel s'étend la direction axiale oblique **D** de la tête **24.** Ce plan **R** s'avère être un plan de symétrie du support mural, confondu avec le plan de coupe **V-V** de la figure 5. On peut mesurer une largeur du support mural **12,** dans une direction perpendiculaire au plan de référence **R.** Cette largeur est sensiblement constante, et en particulier, la largeur mesurée au niveau de la tête **24** est sensiblement identique, à moins de 10% près, à la largeur mesurée au niveau du corps **22.** On peut également mesurer une épaisseur du corps **22,** perpendiculairement au plan d'appui **R.** On constate que l'épaisseur du corps **22** est faible par rapport à sa largeur, de préférence inférieure à la moitié, et de préférence inférieure au quart de la largeur. De façon similaire, on peut mesurer une épaisseur de la tête **24,** dans une direction perpendiculaire à la direction oblique **D** et parallèle au plan de référence **R.** On constate alors que l'épaisseur de la tête **24** est faible par rapport à sa largeur, de préférence inférieure à la moitié, et de préférence inférieure au quart de la largeur.

Le boîtier **16** de la télécommande nomade **10** est constitué de préférence de plusieurs pièces et présente une face arrière **40** et une face avant **42,** situées de part et d'autre et à distance d'un plan médian **M** du boîtier ainsi qu'une extrémité supérieure **10.1** et une extrémité inférieure **10.2.** Comme on l'a évoqué précédemment, la face avant **42** est destinée à constituer ou accueillir une interface de saisie, et le cas échéant de visualisation. Elle peut donc être pourvue d'une ou plusieurs touches **18, 18.1, 18.2,** et le cas échéant d'une diode électroluminescente **20.** Naturellement, d'autres types d'interfaces sont possibles, avec écran et touches multiples, et/ou écran tactile.

La face arrière **40** du boîtier **16** de la télécommande nomade **10** est courbe, en l'occurrence concave, de manière à épouser la forme courbe convexe de la face avant **26** du corps **22** du support mural **12.** La télécommande murale **10** a une largeur plus importante que le support mural **12,** et présente des rebords latéraux **44** qui viennent couvrir les faces latérales **32** du support mural **12** avec un jeu très faible.

De manière remarquable, le boîtier **16** forme un oeillet de passage **46** entre la face arrière **40** et la face avant **42** du boîtier **16.** Par oeillet, on entend ici un trou ouvert de part en part, à une extrémité sur la face arrière **40** et à l'extrémité opposée sur la face avant **42.** L'oeillet **46** présente un axe d'insertion **O** oblique par rapport au plan médian **M** du boîtier, et est conformé de manière à définir une cavité **48** épousant la forme de la tête **24** du support mural **12,** de sorte qu'il est possible d'accrocher la télécommande nomade **10** au support mural **12** dans la position d'accrochage illustrée sur les figures 4 à 6. Dans la position d'accrochage, l'axe d'insertion **O** de l'oeillet **46** est confondu avec la direction oblique **D** de la tête **24.** La face arrière **34** de la tête **24** du support mural **12** est en contact avec une paroi correspondante **48.1** de la cavité **48,** alors que la face avant **36** de la tête **24** est en contact avec une paroi correspondante **48.2** de la cavité **48.** Les parois **48.1, 48.2** sont ascendantes et se rapprochent l'une de l'autre lorsque l'on s'éloigne de la face arrière **40,** de sorte que l'aire de la section de la cavité **48,** mesurée dans un plan quelconque parallèle au plan médian **M,** diminue lorsque l'on s'éloigne de la face arrière **40.** Au moins dans leur partie la plus éloignée de la face arrière **40,** du côté du plan médian **M** situé à l'opposé de la face arrière **40,** les parois **48.1, 48.2** sont situées dans une moitié supérieure de la télécommande **10,** c'est-à-dire sont plus proche de l'extrémité supérieure **10.1** que de l'extrémité inférieure **10.2** de la télécommande **10.** Comme illustré sur la figure 4, la facette sommitale **38** affleure au niveau d'une face avant **42** de la télécommande nomade **10,** en continuité de forme avec la face avant **42** de la télécommande nomade **10.** La facette sommitale **38** est donc visible en position d'accrochage. De face, en non recouverte par la télécommande nomade **10.**

La télécommande nomade **10** présente une hauteur, mesurée verticalement dans le plan de symétrie **V-V,** qui est plus importante que la hauteur du support mural **12.** On minimise ainsi l'impact visuel du support mural **12** en l'absence de télécommande **10** et l'on rend plus perceptible à l'utilisateur la présence ou l'absence de la télécommande **10** sur le support mural **12.** Dans la position d'accrochage, une extrémité supérieure de la télécommande **10** dépasse du support mural vers le haut et se trouve partiellement entre le support mural **12** et le plan d'appui **P.** Une extrémité inférieure de la télécommande nomade **10** dépasse du support mural vers le bas, et constitue une portion facilitant la prise en main de la télécommande nomade **10** pour la décrocher. La face arrière 40 du boîtier **16** de la télécommande **10** peut présenter, dans la partie d'extrémité inférieure, une portion **49** qui, en position d'accrochage, est quasiment tangente au plan **P.** La portion tangente **49** peut correspondre à une surépaisseur locale du boîtier **16** de la télécommande nomade **10** et/ou à une forme concave de la face arrière du boîtier **16.**

Les formes conjuguées de la tête **24** du support mural **12** et de l'oeillet **46** de la télécommande nomade **10** permettent un accrochage efficace de la télécommande nomade **10** et un positionnement précis de la télécommande nomade **10** sur le support mural **12.** Les formes conjuguées de la face arrière **40** de la télécommande nomade **10** et de la face avant **26** du corps **22** du support mural **12,** ainsi que les rebords latéraux **44** de la télécommande **10,** contribuent au bon positionnement de la télécommande **10.** Les formes conjuguées des rebords latéraux **44** de la télécommande **10,** et des faces latérales **32** du support mural **12** contribuent au maintien de la télécommande lors de son utilisation manuelle en position d'accrochage sur son support.

Naturellement, diverses modifications sont possibles. La face avant **26** du corps **22** du support mural **12** peut le cas échéant être concave ou plane, et la face arrière conjuguée **40** du boîtier **16** de la télécommande nomade **10** convexe ou plane. Les rebords latéraux **34** de la télécommande **10** peuvent être omis. La face arrière **28** du support mural peut ne pas être plane, pour autant qu'elle permette de définir trois points de contact avec le mur, et donc un plan d'appui **P** unique. Le plan médian **M** du boîtier n'est pas nécessairement strictement parallèle au plan d'appui **P.** Le plan de référence **R** n'est pas nécessairement un plan de symétrie. Le corps **22** du support mural **12** peut être omis, ou réduit en taille.

Le fait que la facette sommitale **38** de la tête **24** du support mural **12** soit visible en position d'accrochage permet de faire différents choix: on peut choisir pour cette facette sommitale une couleur et un aspect de surface identique à celui de la télécommande, pour des raisons esthétiques. On peut au contraire choisir un contraste entre la facette sommitale **38** et la face avant **42** de la télécommande nomade **10,** pour permettre à l'utilisateur un contrôle visuel du bon accrochage de la télécommande nomade **10.** De manière générale, le mode d'accrochage décrit ici permet une grande liberté de choix dans les formes du support et de la télécommande, qui peuvent s'adapter à différentes esthétiques, anguleuses ou arrondies.

## Revendications

1. Dispositif de télécommande (14) comportant une télécommande nomade (10) et un support mural (12), la télécommande nomade (10) comportant un boîtier (16) présentant une face arrière (40) et une face avant (42), situées de part et d'autre et à distance d'un plan médian (M) du boîtier (16), le boîtier (16) comprenant une cavité (48) ouverte au moins sur la face arrière (40), le support mural (12) présentant une surface (28) d'appui à un mur suivant un plan d'appui (P) et une tête (24) faisant saillie par rapport au plan d'appui (P), la tête (24) pénétrant dans la cavité (48) dans une position d'accrochage de la télécommande nomade (10) de manière à traverser le plan médian (M) du boîtier (16), **caractérisé en ce que** la cavité (48) est conformée de manière à épouser la forme de la tête (24), **en ce que** la tête (24) fait saillie dans une direction oblique (D) ascendante par rapport au plan d'appui (P), et présente au moins une première surface (34, 36) oblique qui, en position d'accrochage, est en contact surfacique avec au moins une première paroi oblique (48.1, 48.2) de la cavité (48).

2. Dispositif de télécommande selon la revendication 1, **caractérisé en ce qu'**au moins une partie de la première paroi oblique (48.1, 48.2) située d'un côté du plan médian (M) opposé à la face arrière (40) étant située dans une moitié supérieure du boîtier (16).

3. Dispositif selon l'une quelconque des revendications précédentes, **caractérisé en ce que** la tête (24) présente une deuxième surface (34, 36) oblique qui, en position d'accrochage, est en contact surfacique avec au moins une deuxième paroi oblique (48.1, 48.2) de la cavité (48).

4. Dispositif de télécommande selon la revendication précédente, **caractérisé en ce que** la première et la deuxième surfaces obliques (34, 36) se rapprochent l'une de l'autre lorsque l'on s'éloigne de la face arrière (40) du boîtier (16) de la télécommande (10).

5. Dispositif de télécommande selon l'une quelconque des revendications précédentes, **caractérisé en ce que** la première surface oblique (34, 36) de la tête (24) du support mural (12) et la première paroi oblique (48.1, 48.2) de la cavité (48) sont au moins partiellement courbes.

6. Dispositif de télécommande selon l'une quelconque des revendications précédentes, **caractérisé en ce que** la cavité (48) est ouverte sur la face avant (42) du boîtier (16) et forme un passage entre la face arrière (40) et la face avant (42) du boîtier (16).

7. Dispositif de télécommande selon la revendication précédente, **caractérisé en ce que** la tête (24) présente une facette sommitale (38) qui, en position d'accrochage, affleure au niveau de la face avant (42) de la télécommande nomade (10), en continuité de forme avec la face avant (42) de la télécommande nomade (10).

8. Dispositif de télécommande selon l'une quelconque des revendications précédentes, **caractérisé en ce que** le support mural (12) comporte un corps (22) présentant une face arrière (28) plane d'appui matérialisant le plan d'appui (P) et constituant la surface d'appui (28), le corps (22) du support mural (12) présentant une face avant (26) opposée à la face plane d'appui (28), la face arrière (40) du boîtier (16) de la télécommande nomade (10) épousant la forme de la face avant (26) du corps (22) du support mural (12) de manière être en contact surfacique avec la face avant (26) du corps (22) du support mural (12) en position d'accrochage.

9. Dispositif de télécommande selon la revendication 8, **caractérisé en ce que** la face avant (26) du corps (22) du support mural (12) est entièrement recouverte par la télécommande nomade (10) en position d'accrochage.

10. Dispositif de télécommande selon l'une quelconque des revendications 8 ou 9, **caractérisé en ce que** le boîtier (16) de la télécommande (10) comporte des rebords latéraux (44) qui encadrent des faces latérales du corps (22) du support mural (12) en position d'accrochage.

11. Dispositif de télécommande selon l'une quelconque des revendications 8 à 10, **caractérisé en ce que** la face arrière (40) du boîtier (16) de la télécommande (10) comporte une portion d'extrémité inférieure qui, en position d'accrochage, est tangente au plan d'appui (P) ou distante de moins d'un millimètre du plan d'appui (P).

12. Dispositif de télécommande selon l'une quelconque des revendications précédentes, **caractérisé en ce que** la tête a une largeur maximale, mesurée perpendiculairement à un plan de référence (R) contenant la direction oblique d'insertion (D) et perpendiculaire au plan d'appui (P), qui est supérieure ou égale à la moitié d'une largeur maximale de la télécommande nomade (10), mesurée en position d'accrochage perpendiculairement au plan de référence (R).

13. Dispositif de télécommande selon l'une quelconque des revendications précédentes, **caractérisé en ce que** la face avant (40) du boîtier (16) de la télécommande nomade (10) est équipée d'une interface de saisie (18).

## Patentansprüche

1. Fernsteuerungsvorrichtung (14), umfassend eine mobile Fernsteuerung (10) und eine Wandhalterung (12), wobei die mobile Fernsteuerung (10) ein Gehäuse (16) umfasst, das eine hintere Seite (40) und eine vordere Seite (42) aufweist, die auf beiden Seiten und in einem Abstand von einer mittleren Ebene (M) des Gehäuses angeordnet sind, wobei das Gehäuse (16) einen Hohlraum (48) umfasst, der mindestens auf der hinteren Seite (40) geöffnet ist, wobei die Wandhalterung (12) eine Oberfläche (28) zur Auflage auf einer Wand gemäß einer Auflageebene (P) und einen Kopf (24) aufweist, der mit Bezug auf die Auflagefläche (P) hervorspringt, wobei der Kopf (24) in den Hohlraum (48) in einer Befestigungsposition der mobilen Fernsteuerung (10) eindringt, so dass er die mittlere Ebene (M) des Gehäuses (16) quert, **dadurch gekennzeichnet, dass** der Hohlraum (48) ausgebildet ist, um die Form des Kopfes (24) zu übernehmen, dadurch, dass der Kopf (24) in einer schrägen (D) aufsteigenden Richtung mit Bezug auf die Auflageebene (P) hervorspringt und mindestens eine erste schräge (34, 36) Ebene darstellt, die, in der Befestigungsposition, in Oberflächenkontakt mit mindestens einer ersten schrägen Wand (48.1, 48.2) des Hohlraums (48) ist.

2. Fernsteuerungsvorrichtung nach Anspruch 1, **dadurch gekennzeichnet, dass** mindestens ein Teil der ersten schrägen Wand (48.1, 48.2), die auf einer Seite der mittleren Ebene (M) gegenüber der hinteren Seite (40) angeordnet ist, auf einer oberen Hälfte des Gehäuses (16) angeordnet ist.

3. Vorrichtung nach einem beliebigen der vorhergehenden Ansprüche, **dadurch gekennzeichnet, dass** der Kopf (24) eine zweite schräge Oberfläche (34, 36) aufweist, die, in der Befestigungsposition, in Oberflächenkontakt mit mindestens einer zweiten schrägen Wand (48.1, 48.2) des Hohlraums (48) ist.

4. Fernsteuerungsvorrichtung nach Anspruch 1, **dadurch gekennzeichnet, dass** sich die erste und die zweite schräge Oberfläche (34, 36) aneinander annähern, wenn man sich von der hinteren Seite (40) des Gehäuses (16) von der Fernsteuerung (10) entfernt.

5. Fernsteuerungsvorrichtung nach einem beliebigen der vorhergehenden Ansprüche, **dadurch gekennzeichnet, dass** die erste schräge Oberfläche (34, 36) des Kopfes (24) der Wandhalterung (12) und die erste schräge Wand (48.1, 48.2) des Hohlraums (48) mindestens teilweise gekrümmt sind.

6. Fernsteuerungsvorrichtung nach einem beliebigen der vorhergehenden Ansprüche, **dadurch gekennzeichnet, dass** der Hohlraum (48) auf der vorderen Seite (42) des Gehäuses (16) offen ist und einen Durchgang zwischen der hinteren Seite (40) und der vorderen Seite (42) des Gehäuses (16) bildet.

7. Fernsteuerungsvorrichtung nach Anspruch 1, **dadurch gekennzeichnet, dass** der Kopf (24) eine oberste Facette (38) aufweist, die, in der Befestigungsposition, auf der Ebene der vorderen Seite (42) der mobilen Fernsteuerung (10) in Formkontinuität mit der vorderen Seite (42) der mobilen Fernsteuerung (10) zum Vorschein kommt.

8. Fernsteuerungsvorrichtung nach einem beliebigen der vorhergehenden Ansprüche, **dadurch gekennzeichnet, dass** die Wandhalterung (12) einen Körper (22) umfasst, der eine ebene hintere Auflageseite (28) aufweist, die die Auflageebene (P) ausmacht und die Auflageoberfläche (28) darstellt, wobei der Körper (22) der Wandhalterung (12) eine vordere Seite (26) aufweist, die der ebenen Auflageseite (28) gegenüber liegt, wobei die hintere Seite (40) des Gehäuses (16) der mobilen Fernsteuerung (10) die Form der vorderen Seite (26) des Körpers (22) der Wandhalterung (12) übernimmt, um in Oberflächenkontakt mit der vorderen Seite (26) des Körpers (22) der Wandhalterung (12) in der Befestigungsposition zu sein.

9. Fernsteuerungsvorrichtung nach Anspruch 8, **dadurch gekennzeichnet, dass** die vordere Seite (26) des Körpers (22) der Wandhalterung (12) vollständig mit der mobilen Fernsteuerung (10) in der Befestigungsposition bedeckt ist.

10. Fernsteuerungsvorrichtung nach einem beliebigen der Ansprüche, 8 bis 9 **dadurch gekennzeichnet, dass** das Gehäuse (16) der Fernsteuerung (10) laterale Ränder (44) umfasst, die laterale Seiten des Körpers (22) der Wandhalterung (12) in der Befestigungsposition einrahmen.

11. Fernsteuerungsvorrichtung nach einem beliebigen der Ansprüche 8 bis 10, **dadurch gekennzeichnet, dass** die hintere Seite (40) des Gehäuses (16) der Fernsteuerung (10) einen unteren Endabschnitt umfasst, der, in der Befestigungsposition, tangential zur Auflageebene (P) oder um mindestens eine Millimeter von der Auflageebene (P) entfernt ist.

12. Fernsteuerungsvorrichtung nach einem beliebigen der vorhergehenden Ansprüche, **dadurch gekennzeichnet, dass** der Kopf eine maximale Breite aufweist, gemessen senkrecht zu einer Referenzebene (R), die die schräge Einführungsrichtung (D) enthält, und senkrecht zur Auflageebene (P), die größer als oder gleich wie die Hälfte einer maximalen Breite der mobilen Fernsteuerung (10) ist, gemessen in der Befestigungsposition, senkrecht zur Referenzebene (R).

13. Fernsteuerungsvorrichtung nach einem beliebigen der vorhergehenden Ansprüche, **dadurch gekennzeichnet, dass** die vordere Seite (40) des Gehäuses (16) der mobilen Fernsteuerung (10) mit einer Erfasungsschnittstelle (18) ausgestattet ist.

## Claims

1. A remote-control device (14) comprising a portable remote control (10) and a wall mounting (12), the portable remote control (10) comprising a housing (16) having a rear surface (40) and a front surface (42), located on either side of and at a distance from a median plane (M) of the housing (16), the housing (16) including a recess (48) open at least on the rear surface (40), the wall mounting (12) having a surface (28) for bearing against a wall along a bearing plane (P) and a head (24) projecting from the bearing plane (P), the head (24) penetrating into the recess (48) in an anchoring position of the portable remote control (10) so as to pass through the median plane (M) of the housing (16), **characterized in that** the recess (48) is shaped so as to match the shape of the head (24), **in that** the head (24) projects in an upward oblique direction (D) relative to the bearing plane (P), and has at least one first oblique surface (34, 36), which, in the anchoring position, is in surface contact with at least one first oblique wall (48.1, 48.2) of the recess (48).

2. The remote control device according to claim 1, **characterized in that** at least part of the first oblique wall (48.1, 48.2) situated on one side of the median plane (M) opposite the rear surface (40) is situated in an upper half of the housing (16).

3. The device according to any one of the preceding claims, **characterized in that** the head (24) has a second oblique surface (34, 36), which, in the anchoring position, is in surface contact with at least one second oblique wall (48.1, 48.2) of the recess (48).

4. The remote control device according to the preceding claim, **characterized in that** the first and second oblique surfaces (34, 36) approach one another when one moves away from the rear surface (40) of the housing (16) of the remote control (10).

5. The remote control device according to any one of the preceding claims, **characterized in that** the first oblique surface (34, 36) of the head (24) of the wall mounting (12) and the first oblique wall (48.1, 48.2) of the recess (48) are at least partially curved.

6. The remote control device according to any one of the preceding claims, **characterized in that** the recess (48) is open on the front surface (42) of the housing (16) and forms a passage between the rear surface (40) and the front surface (42) of the housing (16).

7. The remote control device according to the preceding claim, **characterized in that** the head (24) has an apical facet (38) which, in the anchoring position, is flush with the front surface (42) of the portable remote control (10), in shape continuity with the front surface (42) of the portable remote control (10).

8. The remote control device according to any one of the preceding claims, **characterized in that** the wall mounting (12) includes a body (22) having a planar rear bearing surface (28) embodying the bearing plane (P) and constituting the bearing surface (28), the body (22) of the wall mounting (12) having a front surface (26) opposite the planar bearing surface (28), the rear surface (40) of the housing (16) of the portable remote control (10) matching the shape of the front surface (26) of the body (22) of the wall mounting (12) so as to be in surface contact with the front surface (26) of the body (22) of the wall mounting (12) in the anchoring position.

9. The remote control device according to claim 8, **characterized in that** the front surface (26) of the body (22) of the wall mounting (12) is completely covered by the portable remote control (10) in the anchoring position.

10. The remote control device according to any one of claims 8 or 9, **characterized in that** the housing (16) of the remote control (10) comprises side rims (44) that frame the side surfaces of the body (22) of the wall mounting (12) in the anchoring position.

11. The remote control device according to any one of claims 8 to 10, **characterized in that** the rear surface (40) of the housing (16) of the remote control (10) includes a lower end portion, which, in the anchoring position, is tangential to the bearing plane (P) or less than one millimeter away from the bearing plane (P).

12. The remote control device according to any one of the preceding claims, **characterized in that** the head has a maximum width, measured perpendicular to a reference plane (R) containing the oblique insertion direction (D) and perpendicular to the bearing plane (P), which is greater than or equal to half of a maximum width of the portable remote control (10), measured in the anchoring position perpendicular to the reference plane (R).

13. The remote control device according to any one of the preceding claims, **characterized in that** the front surface (40) of the housing (16) of the portable remote control (10) is equipped with a grasping interface (18).
